Europäisches Patentamt

European Patent Office

Office européen des brevets

(19)

(11) Veröffentlichungsnummer : **0 169 609**
**B1**

(12) # EUROPÄISCHE PATENTSCHRIFT

(45) Veröffentlichungstag der Patentschrift :
24.01.90

(51) Int. Cl.⁵ : **H 03 K 17/08**

(21) Anmeldenummer : **85201137.8**

(22) Anmeldetag : **09.07.85**

(54) Schaltungsanordnung zum Schalten des Stromes in einer induktiven Last.

(30) Priorität : 26.07.84 DE 3427492

(43) Veröffentlichungstag der Anmeldung :
29.01.86 Patentblatt 86/05

(45) Bekanntmachung des Hinweises auf die Patenterteilung : 24.01.90 Patentblatt 90/04

(84) Benannte Vertragsstaaten :
BE DE FR GB IT NL

(56) Entgegenhaltungen :
FR–A– 2 446 557
IEEE JOURNAL OF SOLID-STATE CIRCUITS, Band
SC-10, Nr. 3, Juni 1975, Seiten 168-176, New York, US;
N.O. SOKAL et al.: "Class E-A new class of high-
efficiency tuned single-ended switching power amplifiers"
ELECTRONIQUE INDUSTRIELLE, Nr. 47, Februar
1983, Seiten 27-32, Paris, FR; J.-M. PETER: "Aide à la
commutation et limitation des surtensions"

(73) Patentinhaber : Philips Patentverwaltung GmbH
Wendenstrasse 35 Postfach 10 51 49
D-2000 Hamburg 1 (DE)
DE
N.V. Philips' Gloeilampenfabrieken
Groenewoudseweg 1
NL-5621 BA Eindhoven (NL)
BE FR GB IT NL

(72) Erfinder : Raets, Hubert
Exdel 32
NL-6391 AJ Nieuwenhagen (NL)

(74) Vertreter : Hartmann, Heinrich, Dipl.-Ing. et al
Philips Patentverwaltung GmbH Wendenstrasse 35
Postfach 10 51 49
D-2000 Hamburg 1 (DE)

EP 0 169 609 B1

## Beschreibung

Die Erfindung bezieht sich auf eine Schaltungsanordnung zum Schalten eines Stromes durch eine Last, die einen induktiven Blindwiderstand enthält, mit wenigstens einem Halbleiterschalter, der den Strom durch die Last periodisch mit seinem abwechselnd leitend bzw. nichtleitend geschalteten Hauptstromweg schaltet, zu dem parallel zum Begrenzen der an ihm auftretenden Spannung ein Spannungsbegrenzelement angeordnet ist.

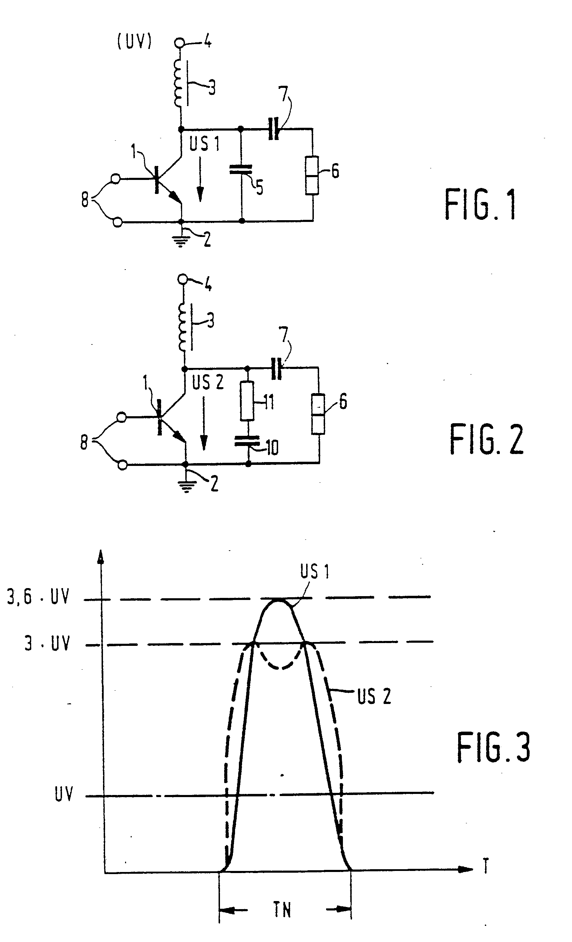

Eine derartige Schaltungsanordnung ist aus dem Aufsatz « Class E-A New Class of High-Efficiency Tuned Single-Ended Switching Power Amplifiers » von Sokal und Sokal, IEEE Journal of Solid-State Circuits, Band SC-10, Nr. 3, Juni 1975, Seiten 168 bis 176, bekannt. Insbesondere ist in der genannten Literaturstelle auf Seite 172 in der Fig. 3 mit zugehörigem Text auf Seite 172, linke Spalte, eine Schaltungsanordnung mit einem Schalttransistor als Halbleiterschalter beschrieben, dessen Emitter mit Massepotential und dessen Kollektor über eine Drossel mit dem positiven Pol einer Gleichspannungsquelle verbunden ist. Parallel zur den Hauptstromweg bildenden Kollektor-Emitter-Strecke des Transistors ist eine als Spannungsbegrenzelement dienende erste Kapazität sowie eine Reihenschaltung aus einer zweiten Kapazität, einer weiteren Spule und einem Lastwiderstand geschaltet. Über seinen Basisanschluß ist der Transistor mit einem Treiber verbunden, durch den er periodisch in den leitenden und in den nichtleitenden Zustand geschaltet wird. Insbesondere beim Schalten des Transistors in den nichtleitenden Zustand tritt an dessen Kollektor-Emitter-Strecke eine Spannung auf, die durch die erste Kapazität in dem Zeitintervall, während dessen der Transistor von dem leitenden in den nichtleitenden Zustand überführt wird, so lange niedrig gehalten wird, bis der Strom im Kollektor des Transistors vollständig auf Null abgeklungen ist. Die erste Kapazität ist darüber hinaus derart bestimmt, daß die Spannung über der Kollektor-Emitter-Strecke beim nächsten Umschalten des Transistors von dem nichtleitenden in den leitenden Zustand wieder auf Null abgefallen ist. Auf diese Weise werden Verluste im Transistor vermieden und somit der Wirkungsgrad der Schaltung erhöht. Außerdem kann dadurch eine Gleichspannungsquelle mit einer höheren Spannung verwendet werden, als dies in einer ohne die erste Kapazität aufgebauten Schaltungsanordnung möglich wäre.

Bedingt durch die induktive Last und die Drossel wird die erste Kapazität während der Zeit, in der sich der Transistor im nichtleitenden Zustand befindet, aufgeladen, und über der Kollektor-Emitter-Strecke treten Spannungsspitzen auf, deren Höhe ein Mehrfaches der Spannung der Gleichspannungsquelle beträgt. Diese Spannungsspitzen können zu einem Spannungsdurchbruch der Kollektor-Emitter-Strecke auch nach deren Umschalten in den nichtleitenden Zustand führen, wodurch nicht nur erneut Verluste im Transistor auftreten, sondern dieser auch zerstört werden kann.

Die Erfindung hat die Aufgabe, eine Schaltungsanordnung der eingangs genannten Art dahingehend zu verbessern, daß die Spannungsspitzen am Hauptstromweg des Halbleiterschalters verringert und damit die Gefahr eines Durchbruchs vermieden wird.

Die Aufgabe wird erfindungsgemäß dadurch gelöst, daß das Spannungsbegrenzelement eine Resonanz aufweist mit einer Schwingungsperiode, die höchstens nahezu 2/3 des Zeitintervalls beträgt, in dem der Hauptstromweg nichtleitend ist.

Bei der erfindungsgemäßen Schaltungsanordnung wird nach dem Umschalten des Halbleiterschalters in den nichtleitenden Zustand am Spannungsbegrenzelement eine periodische Spannung hervorgerufen, deren Schwingfrequenz gleich der Resonanzfrequenz des Spannungsbegrenzelements ist. Diese periodische Spannung wird der am nichtleitenden Hauptstromweg auftretenden Spannungsspitze überlagert. Der Erfindung liegt die Erkenntnis zugrunde, daß durch Wahl der Schwingungsperiode der periodischen Spannung diese mit der Spannungsspitze derart überlagert werden kann, daß die Amplitude der Spannungsspitze durch eine gleichzeitig auftretende, entgegengesetzt gerichtete Halbschwingung in der periodischen Spannung vermindert werden kann.

Das Spannungsbegrenzelement wird im übrigen vorteilhaft derart dimensioniert, daß es für die Schaltungsanordnung im Betrieb mit der Frequenz, mit der der Transistor den Strom in der Last periodisch schaltet, gegenüber dem Spannungsbegrenzelement nach dem Stand der Technik unverändert wirkt. Das bedeutet beispielsweise, daß das erfindungsgemäß ausgebildete Spannungsbegrenzelement bei der Frequenz, mit der der Transistor den Strom durch die Last schaltet, die gleiche Impedanz aufweist wie das Spannungsbegrenzelement nach dem Stand der Technik, also beispielsweise wie die dort eingesetzte erste Kapazität. Bei einer derartigen Dimensionierung des erfindungsgemäß ausgebildeten Spannungsbegrenzelements ist keine Veränderung der übrigen Elemente der Schaltungsanordnung zum Anpassen an das Spannungsbegrenzelement erforderlich.

Die Erfindung hat den Vorteil, daß der Halbleiterschalter weniger hohen Sperrspannungen standhalten muß, wodurch es möglich ist, in einer Schaltungsanordnung für einen bestimmten Einsatzzweck einen weniger spannungsfesten und damit billigeren Halbleiterschalter zu verwenden. Darüber hinaus ist bei der erfindungsgemäß ausgebildeten Schaltungsanordnung der Wirkungsgrad für die Übertragung elektrischer Energie aus der Gleichspannungsquelle in die Last gegenüber den Schaltungsanordnungen nach dem Stand der Technik durch den veränderten zeitlichen Verlauf der Spannung über dem Hauptstromweg des Halbleiterschalters im nichtleitenden Zustand erhöht.

In einer Weiterbildung der erfindungsgemäßen Schaltungsanordnung, bei der die Zeitintervalle in einer Schaltperiode des Halbleiterschalters, in denen der Hauptstromweg leitend bzw. nichtleitend ist, wenigstens nahezu gleich sind, weist das Spannungsbegrenzelement seine Resonanz beim Dreifachen der Schaltfrequenz des Halbleiterschalters auf. In diesem Fall, in dem das Tastverhältnis des Halbleiterschalters wenigstens nahezu 50 % beträgt, wird ein besonders günstiger Wirkungsgrad der Schaltungsanordnung erreicht.

Nach einer weiteren Ausgestaltung der Erfindung umfaßt das Spannungsbegrenzelement einen Reihenresonanzkreis. Dieser Reihenresonanzkreis, der im einfachsten Fall aus einem Kondensator und einer Spule besteht, bildet bei seiner Resonanzfrequenz für die Spannung über dem Hauptstromweg des Halbleiterschalters einen Kurzschluß. Spule und Kondensator des Reihenresonanzkreises können auf einfache Art beispielsweise so dimensioniert werden, daß die Impedanz des Reihenresonanzkreises bei der Schaltfrequenz des Halbleiterschalters der Impedanz der aus dem Stand der Technik als Spannungsbegrenzelement bekannten (ersten) Kapazität entspricht.

Einige Ausführungsbeispiele der Erfindung sind in der Zeichnung dargestellt und werden im nachfolgenden näher beschrieben. Es zeigen

Fig. 1 eine Schaltungsanordnung nach dem Stand der Technik,

Fig. 2 ein Ausführungsbeispiel der Erfindung,

Fig. 3 die zeitlichen Verläufe der Spannungen über den Halbleiterschaltern in den Schaltungsanordnungen nach Fig. 1 und 2.

Fig. 1 zeigt eine Schaltungsanordnung nach dem Stand der Technik. Ein als Transistor ausgebildeter Halbleiterschalter 1 ist mit seinem Emitter mit einem Masseanschluß 2 und mit seinem Kollektor über eine Drossel 3 mit dem positiven Pol 4 einer Gleichspannungsquelle verbunden. Parallel zum Hauptstromweg des Halbleiterschalters 1, der im vorliegenden Fall durch die Kollektor-Emitter-Strecke des Transistors gebildet ist, ist eine erste Kapazität 5 als Spannungsbegrenzelement sowie eine einen induktiven Blindwiderstand enthaltende Last 6 angeordnet. Mit der Last 6 in Reihe geschaltet ist eine zweite Kapazität 7, die einen Gleichstromkurzschluß zwischen dem positiven Pol 4 der Gleichspannungsquelle und dem Masseanschluß 2 verhindert und die derart bestimmt ist, daß sie als Teil des Lastnetzwerks mit dazu beiträgt, die gewünschten Kurvenformen von Strom und Spannung am Schalter zu gestalten.

Der Schaltungsanordnung wird über Eingangsanschlüsse 8 ein Schaltsignal zugeleitet, durch das der als Transistor ausgebildete Halbleiterschalter 1 über seinen Basisanschluß periodisch abwechselnd in den leitenden und in den nichtleitenden Zustand geschaltet wird. Im leitenden Zustand fließt vom positiven Pol 4 der Gleichspannungsquelle über die Drossel 3 und den Hauptstromweg des Halbleiterschalters 1 ein Strom zum Masseanschluß 2. Nach dem Umschalten des Halbleiterschalters in den nichtleitenden Zustand fließt ein durch das Umladen der Energie (vom Blindwiderstand der Last 6 in die Kapazität 7 und von dieser wieder zurück in den Blindwiderstand) hervorgerufener Strom über Kapazität 5, zuerst in Richtung Masseanschluß 2 und danach in entgegengesetzter Richtung. Über dem Hauptstromweg des Halbleiterschalters 1 baut sich dabei eine Spannung US1 auf, deren Verlauf über der Zeit t im Bereich des Zeitintervalls tn, in dem der Hauptstromweg nichtleitend ist, durch die ausgezogene Kurve in Fig. 3 dargestellt ist. Es tritt also über dem Hauptstromweg des Halbleiterschalters 1 eine Spannungsspitze auf, deren Amplitude in einer praktischen Ausführung der Schaltungsanordnung nach Fig. 1 beispielsweise dem 3,6-fachen der von der Gleichspannungsquelle an ihrem positiven Pol 4 gelieferten Spannung UV entspricht.

Fig. 2 zeigt ein Ausführungsbeispiel für eine erfindungsgemäße Schaltungsanordnung. Mit Fig. übereinstimmende Teile der Schaltungsanordnung nach Fig. 2 sind mit gleichen Bezugszeichen dargestellt und entsprechend zu Fig. 1 beschrieben. Die in Fig. 1 als Spannungsbegrenzelement verwendete erste Kapazität 5 ist in der Schaltungsanordnung nach Fig. 2 durch einen Reihenschwingkreis, bestehend aus einer Schwingkreiskapazität 10 und einer Schwingkreisinduktivität 11, ersetzt. Der Reihenschwingkreis 10, 11 ist derart dimensioniert, daß er eine Resonanz aufweist mit einer Periodendauer, die 2/3 des Zeitintervalls tn entspricht, in dem der Hauptstromweg des Halbleiterschalters 1 nichtleitend ist. Schwingkreiskapazität 10 und Schwingkreisinduktivität 11 sind weiterhin vorzugsweise derart gewählt, daß die Impedanz des Reihenschwingkreises bei der Frequenz des über die Einganganschlüsse 8 zugeführten Schaltsignals gerade gleich der Impedanz der ersten Kapazität 5 in Fig. 1 bei dieser Frequenz ist. Dann sind alle übrigen Teile der Schaltungsanordnung nach Fig. 2 gleich den entsprechenden Teilen der Schaltungsanordnung nach Fig. 1 dimensioniert.

In Fig. 3 ist der zeitliche Verlauf der Spannung US2 über dem Hauptstromweg des Halbleiterschalters 1 während des Zeitintervalls tn, in dem der Halbleiterschalter 1 sich im nichtleitenden Zustand befindet, durch eine gestrichelte Linie dargestellt. Der in der Schaltungsanordnung nach Fig. 1 auftretenden Spannungsspitze US1 ist jetzt eine Spannung aus drei Halbschwingungen überlagert, wodurch sich insgesamt ein Spannungsverlauf mit niedrigerer Amplitude ergibt. Dieser liegt bei dem obengenannten Beispiel beim Dreifachen der von der Gleichspannungsquelle an ihrem positiven Pol abgegebenen Spannung UV.

In den vorstehend beschriebenen Beispielen ist als Halbleiterschalter stets ein bipolarer Transistor vom npn-Typ verwendet worden. Natürlich können statt dessen auch Halbleiterschalter anderer Bauformen eingesetzt werden, beispielsweise bipolare Transistoren vom pnp-Typ, Feldeffekttransistoren, sog. Bimostransistoren, Thyristoren und dergleichen.

## Patentansprüche

1. Schaltungsanordnung zum Schalten eines Stromes durch eine Last, die einen induktiven Blindwiderstand enthält, mit wenigstens einem Halbleiterschalter, der den Strom durch die Last periodisch mit seinem abwechselnd leitend bzw. nichtleitend geschalteten Hauptstromweg schaltet, zu dem parallel zum Begrenzen der an ihm auftretenden Spannung ein Spannungsbegrenzelement angeordnet ist, dadurch gekennzeichnet, daß das Spannungsbegrenzelement (10, 11) eine Resonanz aufweist mit einer Schwingungsperiode, die höchstens nahezu 2/3 des Zeitintervalls (tn) beträgt, in dem der Hauptstromweg nichtleitend ist.

2. Schaltungsanordnung nach Anspruch 1, bei der die Zeitintervalle in einer Schaltperiode des Halbleiterschalters, in denen der Hauptstromweg leitend bzw. nichtleitend ist, wenigstens nahezu gleich sind, dadurch gekennzeichnet, daß das Spannungsbegrenzelement (10, 11) beim Dreifachen der Schaltfrequenz des Halbleiterschalters (1) seine Resonanz aufweist.

3. Schaltungsanordnung nach Anspruch 1 oder 2, dadurch gekennzeichnet, daß das Spannungsbegrenzelement (10, 11) einen Reihenresonanzkreis umfaßt.

## Claims

1. A circuit arrangement for switching a current through a load which comprises an inductive dummy resistor, in which at least one semiconductor switch switches the current through the load periodically by means of its main current path switched alternately to the conductive and the non-conductive state, which has connected parallel to it a voltage-limiting element for limiting the voltage applied to it, characterized in that the voltage-limiting element (10, 11) has a resonance having an oscillation period which is at most approximately 2/3 of the time interval (tn), in which the main current path is nonconducting.

2. A circuit arrangement as claimed in Claim 1, in which the time intervals in a switching period of the semiconductor switch, in which the main current path is conducting or non-conducting, are at least substantially equal, characterized in that the voltage-limiting element (10, 11) has its resonance at a value equal to three times the switching frequency of the semiconductor switch (1).

3. A circuit arrangement as claimed in Claim 1 or 2, characterized in that the voltage-limiting element (10, 11) comprises a series resonant circuit.

## Revendications

1. Montage de circuit pour la commutation d'un courant à travers une charge contenant une réactance inductive munie d'au moins un commutateur semiconducteur assurant la commutation périodique du courant à travers la charge par son trajet de courant principal commuté alternativement à l'état conducteur respectivement non conducteur, un élément limiteur de tension étant disposé parallèlement audit trajet de courant principal pour la limitation de la tension qui se produit, caractérisé en ce que l'élément limiteur de tension (10, 11) présente une résonance dont la période d'oscillation est au maximum égale à environ 2/3 de l'intervalle de temps (tn) dans lequel le trajet de courant principal n'est pas conducteur.

2. Montage de circuit selon la revendication 1, dans lequel les intervalles de temps dans une période de commutation du commutateur semiconducteur dans laquelle le trajet de courant principal est conducteur respectivement non conducteur sont au moins pratiquement égaux, caractérisé en ce que l'élément limiteur de tension (10, 11) présente sa résonance au triple de la fréquence de commutation du commutateur semiconducteur (1).

3. Dispositif de commutation selon la revendication 1 ou 2, caractérisé en ce que l'élément limiteur de tension (10, 11) présente un circuit de résonance série.

FIG.1

FIG.2

FIG.3